# EUROPEAN PATENT APPLICATION

(11) **EP 1 780 299 A1**
(43) Date of publication of application: **02.05.2007**
(21) Application number: 05740996.3
(22) Date of filing: 18.05.2005
(51) Int. Cl.: C23C 14/34, G11B 7/24, G11B 7/26

(54) **SPUTTERING TARGET FOR THIN FILM FORMATION, DIELECTRIC THIN FILM, OPTICAL DISK, AND PROCESS FOR PRODUCING THE SAME**

(30) Priority: 29.06.2004 JP 2004191149
(71) Applicant: Pioneer Corporation, Tokyo 153-8654 (JP)
(72) Inventor: HOSODA, Yasuo, c/o PIONEER CORPORATION, Tsurugashima-shi, Saitama 350-2288 (JP); HIGUCHI, Takanobu, c/o PIONEER CORPORATION, Tsurugashima-shi, Saitama 350-2288 (JP); UENO, Takashi, c/o DEPT Corporation, Tokyo 100-0005 (JP)
(74) Representative: Haley, Stephen
(86) International application number: PCT/JP2005/009101
(87) International publication number: WO 2006/001138

(57) **Abstract**

Diffusion of water or oxygen present in the dielectric protection film is restrained by eliminating free oxygen in an oxide thin film while maintaining the characteristics of a dielectric protection film. As the dielectric material for forming a dielectric protection film for an optical disc or the like, an oxide mixture thin film of a niobium oxide and one of a silicon oxide and a titanium oxide is used. In a preferable example, a target made of a niobium oxide as the main component with 1 to 30% by weight of a silicon oxide added is used for formation of an oxide thin film by sputtering. Moreover, the oxide thin film is formed preferably in a nitrogen atmosphere. A nitrogen containing oxide thin film is produced by carrying out sputtering using a target with the oxygen lacked and a minute amount of nitrogen added. Thereby, a thin film having little reducing function and a high barrier property while having the characteristics comparable to a complete oxide can be produced.

## Description

### Technical Field

The present invention relates to a technique for forming an oxide thin film.

### Background Technique

In a recording type optical disc such as an inorganic additional recording type disc, a phase change disc and an optical magnetic disc, since a recording film of an inorganic material reacts with oxygen or water so as to be modified to an oxide or a hydroxide, it becomes unusable as time passes by. For preventing the phenomenon, a protection film of a transparent dielectric substance is provided to the optical discs. In the same manner, a display element of a flat panel display such as a plasma display or an electron light emitting display is provided with a transparent protection film for preventing corrosion by reaction with oxygen or water. The recording films and the display element films as mentioned above are called a medium film as the general term.

The oxide thin film is a thin film effective as a protection film for a dielectric protection layer for a recording disc or a protection layer for a flat panel display. As the film forming method, various methods are adopted. For the reasons of the film forming time reduction and the simple film forming device, the sputtering method is frequently used. At the time, for reduction of the film forming time, a method of producing the thin film by preliminarily producing a target having a high sputtering efficiency by partially lacking the oxygen from the oxide, instead of an oxide having a low sputtering rate, and introducing the oxygen at the time of forming a film thereby to form the thin file by reactive sputtering has conventionally been used frequently. Moreover, according to the target with the lack of the oxygen, since the conductivity as a metal can also be improved, the DC sputtering can be performed so that the equipment can be provided further inexpensively, and thus it is advantageous.

Conventionally, at the time of forming an oxide thin film, any of the following methods has been adopted commonly.
(A) A method of forming an oxide thin film by deposition using a metal target while reacting in an atmosphere including oxygen
(B) A method of forming a thin film as it is or while making up for the lacked oxygen by adding a minute amount of oxygen to such a degree that the oxygen lack can be compensated, using an oxide target

However, according to both the methods (A) and (B), since the oxygen amount of the oxide thin film is excessive and unstable, in the applied fields of the dielectric protection layer for an optical disc, the flat panel display, the semiconductor, or the like, in which the oxide thin film is used frequently, deterioration by aging and the characteristic fluctuation of the formed oxide film with the excessive or unstable oxygen are problematic.

For example, according to an oxide thin film with the excessive oxygen, since excessive oxygen becomes free, in the case the oxide thin film is active to the metal layer or other layers to be formed adjacently, it is reacted at the interface with the layers so as to form a product, and phenomena of deteriorating the effective inter-layer characteristics are generated as a result.

For avoiding the phenomena, a technique of forming a film with lacking the nitrogen in a nitride or the oxygen in an oxide in a reducing atmosphere has been known (see the patent document 1). However, if the nitrogen or the oxygen is lacked until a sufficient effect can be obtained in the technique, the optical characteristics of the protection layer are changed. Specifically, a problem of deteriorating the effect as a transparent protection film due to an increase of the light absorption by the protection film has been involved.

Moreover, in the case of an oxygen lacking state, since the reducing function works further strongly, increase of the oxygen lacking amount according to time passage does not provide or continue an effect suitable for the purpose of the oxide film formation, or the like, and thus it is problematic.

From these viewpoints, various skills have been applied for the production apparatus for forming an oxide thin film or the forming materials, however, a technique for the essential improvement has not been obtained, and thus the problem remains in the current circumstances.
Patent document 1: Japanese Patent Application Laid-Open (JP-A) No. 1-133229

### DISCLOSURE OF THE INVENTION

### Problem to be solved by the Invention

As the problems that the present invention is to solve, the above-mentioned problems can be presented as an example. An object of the present invention is to restrain diffusion of water or oxygen present in the transparent dielectric protection film by eliminating free oxygen in an oxide thin film while maintaining the characteristics of a transparent dielectric protection film.

### Means for Solving the Problem

In a preferable form of the present invention, as the dielectric material for forming a dielectric protection film for an optical disc or the like, an oxide mixture thin film of a niobium oxide and one of a silicon oxide and a titanium oxide is used. As the dielectric material used for a protection film for an optical disc or the like, an oxide mixture of a zinc sulfide (ZnS) and a silicon oxide (SiO₂) or the like is known. In consideration of the environment, a niobium oxide is used as the substitute for the zinc sulfide, avoiding the use of zinc (Zn). In a preferable example, it is preferred to use a target made of a niobium oxide as the main component with 1 to 30% by weight of a silicon oxide added for formation of an oxide thin film by sputtering.

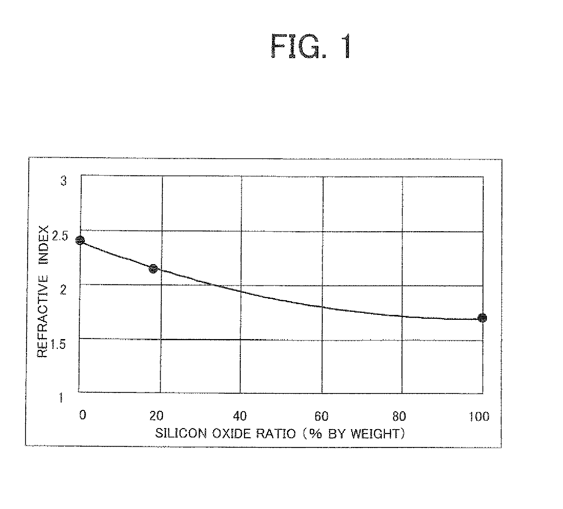

Although addition of the silicon oxide provides the effect of improving the transparency required to a transparent dielectric protection film, as to the thin film refractive index observed with a 400 nm wavelength light beam, the silicon oxide is only 1.7 whereas Nb₂O₅ is 2.4. FIG. 1 shows the relationship between the ratio of the silicon oxide contained in the transparent dielectric protection film and the refractive index of the transparent dielectric protection film. Since a high refractive index of 2.0 or more is required in the optical disc application for ensuring the reflection ratio, it is preferable to add the silicon oxide to 30% by weight at most. However, as long as the optical characteristics required for a transparent dielectric protection film permit, addition of the silicon oxide to amount more than 30% by weight involves no problem.

The oxide thin film functioning as a dielectric protection film is preferably a composite oxide containing a niobium oxide of a low electric resistance with the theoretical composition value of Nb₂O₃ as the main component, and at least one kind of a silicon oxide and a titanium oxide. Since the Nb₂O₃ having the conductivity is used, thin film formation by the DC sputtering can be performed. Moreover, since the silicon oxide or the titanium oxide is contained, the transparency required for a dielectric protection film can be obtained.

It is preferable that the composite oxide is formed to a thin film in a nitrogen atmosphere. It is preferable that the oxide thin film is produced by using a target with the oxygen lacked and by the reactive sputtering introducing the oxygen at the time of forming a film, from the viewpoint of sputtering rate. However, in the case of the film formation by the reactive sputtering with the oxygen introduced, the oxide thin film contains free oxygen or it is in an excessively oxidized state. Since an oxide in the excessively oxidized state has a strong reducing function and the free oxygen also has the oxidizing function of the adjacent other metals or the like, in an optical disc or the like, the recording film or the reflection film adjacent to the dielectric protection layer is oxidized, or the adverse effect of the reaction with a metal comprising the oxide or the like is generated so as to remarkably deteriorate the storage durability. Therefore, a nitrogen containing oxide thin film is produced by sputtering using a target with the oxygen lacked and adding a minute amount of nitrogen. Thereby, it is possible toproduce a thin film having little reducing function and a high barrier property while maintaining the characteristics comparable to a complete oxide.

A composite oxide produced in this manner is preferable as a dielectric protection layer for an optical disc. In particular, in the case that a layer adjacent to the dielectric protection layer in an optical disc contains at least one metal of Al and Ag, or in the case that the layer has the nature of producing by reaction a metal to be easily oxidized such as Bi, Fe by use, the reaction with the metals can be prevented by using a nitrogen containing oxide thin film with little reducing function as mentioned above. Thus, the characteristics deterioration of the optical disc can be prevented, and thus it is extremely preferable.

Moreover, in a preferable form of the present invention, in a production method of an optical disc, a process of forming a dielectric protection layer by sputtering, in which the oxygen lack in an oxide thin film is compensated by mixing nitrogen, is provided. Accordingly, by compensating the valence number lacking part of the oxide by adding nitrogen instead of adding a minute amount of oxygen in the sputtering process, a nitrogen containing oxide thin film is formed. Since the oxide thin film with the nitrogen atoms mixed in the valence number lacking part of the oxide restrains the reducing function of the oxide with the contained nitrogen in an oxygen lacking state, the material stabilization can be realized in a state with the required oxide characteristics maintained. Therefore, by providing a dielectric protection layer of the nitrogen containing oxide thin film, reaction with the adjacent recording film or the reflection film can be prevented so that an optical disc with little deterioration even after repeated recording and reproduction can be produced.

### BRIEF DESCRIPTION OF THE DRAWINGS

FIG. 1 is a graph showing the relationship between the silicon oxide ratio contained in a transparent dielectric protection film and the refractive index of the transparent dielectric protection film.
FIG. 2 schematically shows a sputtering device according to an embodiment of the present invention.
FIG. 3 schematically shows the structure of an optical disc according to the embodiment.
FIG. 4 (a) shows the thicknesses of each layer of the optical disc according to the embodiments and the comparative example, FIG. 4(b) shows the target compositions used in the film formation of the dielectric protection layers of the embodiments and the comparative example, the sputtering film forming atmosphere gases, and the optical constants of the produced oxide thin films, and FIG. 4(c) shows the characteristics (jitter) of the optical discs according to the embodiments and the comparative example.

### BRIEF DESCRIPTION OF THE REFERENCE NUMBER

- 10: chamber
- 11: cathode
- 12: anode
- 13: substrate
- 15: high voltage direct current power source
- 20: target
- 21: thin film

### DETAILED DESCRIPTION OF THE PREFERRED EMBODIMENTS

Hereinafter, preferable embodiments of the present invention will be explained with reference to the drawings.

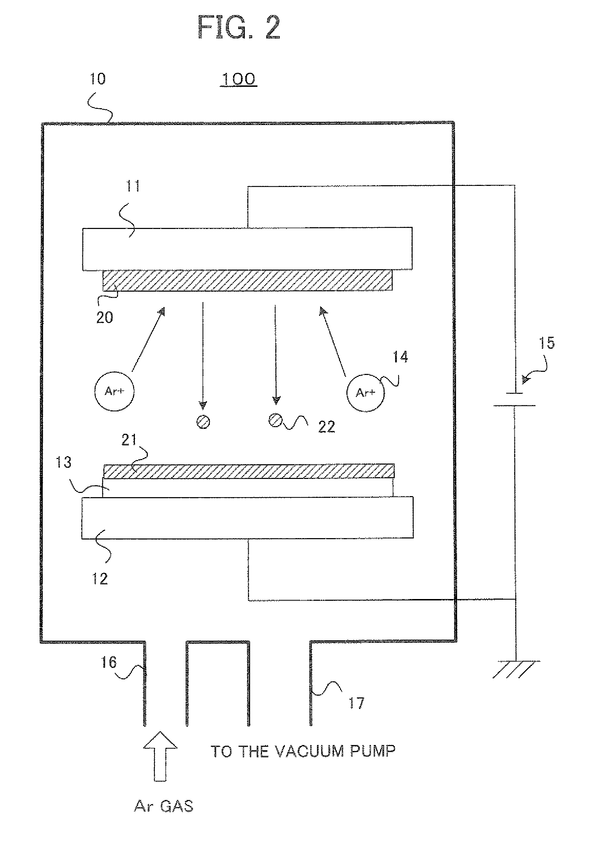

FIG. 2 schematically shows the sputtering device according to the embodiment of the present invention. The sputtering device 100 includes a cathode 11 and an anode 12 disposed facing with each other in a chamber 10. A target 20 of a metal, an oxide, or the like is disposed on the cathode 11, and a substrate 13 to be the subject of the thin film formation is disposed on the anode 12. The chamber 10 is provided with an inlet opening 16 for introducing an inert gas such as argon, and a pipe 17 connected with an unshown vacuum pump. The cathode 11 and the anode 12 are connected with a high pressure direct current power source 15.

In the sputtering process, with keeping the inside of the chamber 10 in a vacuum state by the vacuum pump, a direct current high voltage is applied between the cathode 11 and the anode 12 while introducing argon gas. Thereby, the ionized argon (Ar⁺) 14 collides with the target 20, and repelled and returned target substances 22 form a thin film 21 on the substrate 13 disposed on the anode 12. In the case of carrying out the reactive sputtering, a minute amount of oxygen (O₂) or nitrogen (N₂) is introduced into the chamber 10 together with the argon gas.

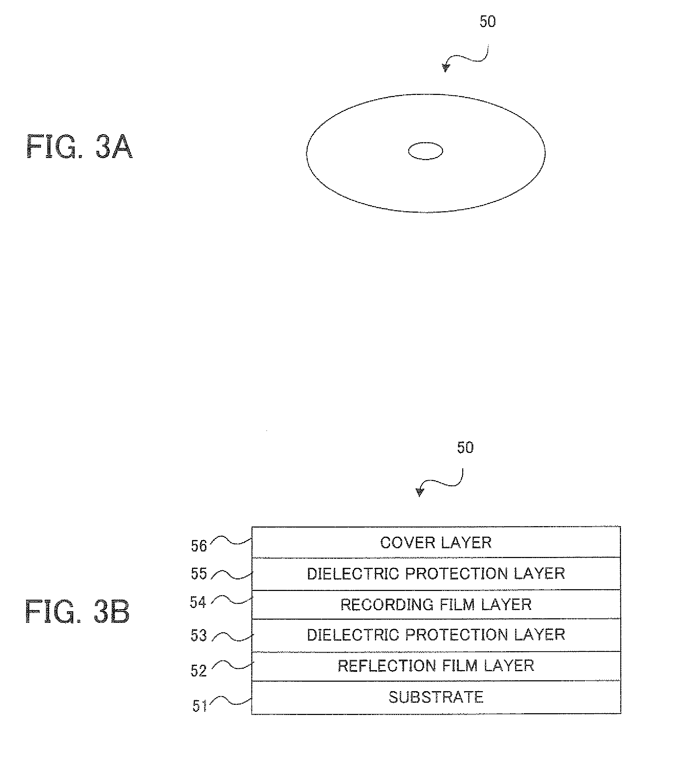

FIG. 3 schematically shows the structure of the optical disc according to the embodiment. FIG. 3(a) shows the external appearance of the optical disc 50, and FIG. 3(b) shows the layer structure of the optical disc 50. As shown in FIG. 3(b), the optical disc 50 has a reflection film layer 52, a dielectric protection layer 53, a recording film layer 54, a dielectric protection layer 55 and a cover layer 56 laminated and formed on a substrate 51. The oxide thin film according to the present invention is formed on the optical disc 50 as the dielectric protection layers 53 and 55.

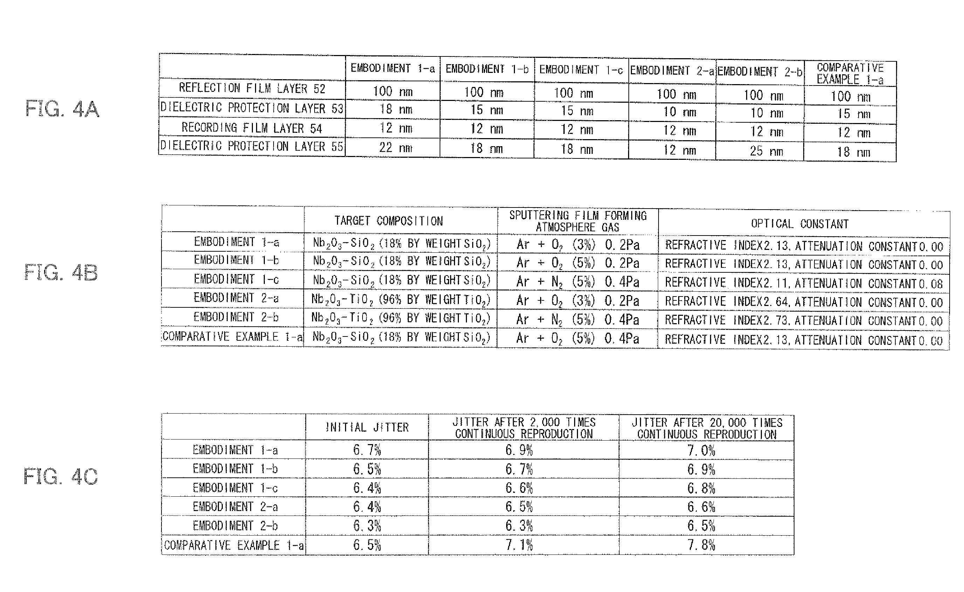

Next, the embodiments and the comparative example of the optical disc 50 will be explained with reference to FIG. 4. FIG. 4(a) shows the thicknesses of each layer of the optical disc according to the embodiments and the comparative example. FIG. 4(b) shows the target compositions, the sputtering film forming atmosphere gases used in the film formation of the dielectric protection layers, and the refractive indices and the attenuation constants as the optical constants of the produced oxide thin films, according to the embodiments and the comparative example. The attenuation constant shows the light absorption degree by the thin film. A larger numerical value shows larger light absorption. For comparison, the same materials were used other than the dielectric protection layer. The disc-shaped substrate 51 made of a polycarbonate resin, having a 1.1 mm thickness and a 12 cm diameter, is provided with spiral grooves of a 0.320 µm pitch. The reflection film layer 52 made of a silver alloy, the dielectric protection layer 53, and the recording film layer 54 made of Bi-Ge-N, and the dielectric protection layer 55 were laminated in this order on the substrate 51 by the sputtering method. Furthermore, a polycarbonate sheet was attached thereon using a ultraviolet ray curable resin as the adhesive so as to produce the 0.1 mm thickness light incident side substrate (cover layer) 56.

The embodiments 1-a to 1-c use a mixture of a niobium oxide (Nb₂O₃) and a silicon oxide (SiO₂) as the target in the sputtering. In the Nb₂O₃-SiO₂ as the target, the SiO₂ amount was 18% by weight in either case.

The atmosphere gas used for the sputtering process is argon to which 3% of oxygen is added by a 0.2 Pa gas pressure in the embodiment 1-a, argon to which 5% of oxygen is added by a 0.2 Pa gas pressure in the embodiment 1-b, and argon to which 5% of nitrogen is added by a 0.4 Pa gas pressure in the embodiment 1-c.

In the embodiments 2-a and 2-b, a mixture of a niobium oxide (Nb₂O₃) and a titanium oxide (TiO₂) is used as the target in the sputtering, and the TiO₂ amount is in both cases 96% by weight. The atmosphere gas used for the sputtering process is argon to which 3% by weight of oxygen is added by a 0.2 Pa gas pressure in the embodiment 2-a, and argon to which 5% of nitrogen is added by a 0.4 Pa gas pressure in the embodiment 2-b.

In the comparative example 1-a, a mixture of a niobium oxide (Nb₂O₃) and a silicon oxide (SiO₂) is used as the target in the sputtering, and the SiO₂ amount is 18% by weight. The atmosphere gas used for the sputtering process is argon to which 5% by weight of oxygen is added by a 0.4 Pa gas pressure.

FIG. 4(c) shows the characteristics (jitter) of the optical discs according to the embodiments and the comparative example. As to the measurement conditions, a 1-7 modulation random pattern was recorded on the guide groove surface projecting to the light incident side on the optical disc with the oxide thin film formed as the dielectric protection layers 53 and 55, by using an optical head with an objective lens having a 0.85 numerical aperture at a 4.92 m/s linear speed and with a 405 nm wavelength. For recording, a multi-pulse type strategy was used, and the window width was 15.15 nsec.

As it is understood from FIG. 4(c), in the all embodiments, preferable jitters were obtained without remarkable deterioration of the jitter even by the continuous reproduction.

On the contrary, in the comparative example 1-a, the jitter value is deteriorated by the continuous reproduction. Deterioration with respect to the initial jitter is 20% as the initial jitter ratio, and a preferable value cannot be maintained. As it is learned from FIG. 4(b), as to the comparative example 1-a and the embodiment 1-b, the pressure of the sputtering film forming atmosphere gas is higher in the comparative example (embodiment 1-b: 0.2 Pa, comparative example 1-a: 0.4 Pa). It is understood that the characteristic deterioration is generated because the oxide thin film in the comparative example 1-a is in an excessive oxygen state (excessively oxidized state). That is, in this recording disc, since a metal bismuth easily oxidized is generated in the recording film by recording, according to the optical disc produced so as to have the oxide in the excessively oxidized state by the film forming method of the comparative example, it is apparent that the free oxygen drastically reacts with the metal bismuth immediately after recording to produce a reaction product, thereby deteriorating the disc characteristics.

On the contrary, according to the optical disc produced with an appropriate amount of oxygen added as in the embodiments 1-a and 1-b, as shown in FIG. 4(c), it is confirmed that the characteristic deterioration can be restrained so that the performance as a sufficient dielectric protection film as the material can be provided.

However, as it is understood by the comparison between the film forming atmosphere gases of the embodiments 1-a and 1-b and the comparative example 1-a, according to the film forming method by sputtering with the oxygen introduced, the oxygen introduction flow rate and the gas pressure should be adjusted strictly. Then, instead of the minute adjustment of the oxygen introduction amount and the gas pressure, in the embodiment 1-c, film formation was carried out with a minute amount of nitrogen added instead of the oxygen. The produced oxide thin film maintains the characteristics as the dielectric protection layer, and the characteristics deterioration is not observed. Such an oxide thin film formed by sputtering with the nitrogen introduction has the nitrogen atoms introduced into the valence number lacking part of the oxide so that the contained nitrogen restrains the reducing function of the oxide in the oxygen lacking state. Thereby, the reaction at the interface with the film to be contacted with the dielectric protection layer can effectively be restrained, and the material stabilization can be realized in a state with the required oxide characteristics maintained.

In the embodiments 1-a to 1-c, a mixture of a niobium oxide (Nb₂O₃) and a silicon oxide (SiO₂) is used as the target, and in the embodiments 2-a and 2-b, a mixture of a niobium oxide (Nb₂O₃) and a titanium oxide (TiO₂) is used as the target. In the embodiment 2-a, a film is formed by sputtering with oxygen added, and in the embodiment 2-b, a film is formed by sputtering with nitrogen added. As shown in FIG. 4(c), the optical discs of the embodiments 2-a and 2-b do not show the characteristics (jitter) deterioration by the continuous reproduction. Therefore, it is learned that the formed oxide thin film satisfies the performance as the dielectric protection layer also in the case a mixture of a titanium oxide is used as the target.

### [Modified embodiment]

The present invention is characterized in that an oxide thin film functioning as a protection layer for a recording medium such as an optical disc is formed by the sputtering method using a target containing a niobium oxide as the main component and either one kind of a silicon oxide and a titanium oxide. Therefore, in the recording medium using an oxide thin film according to the present invention, the kinds of the other films are not limited. For example, the present invention can be applied to various kinds of optical discs having a protection layer, such as a re-writable type recording disc using a phase change material such as SbTe for a recording film and an organic pigment type recording disc using a pigment film for a recording film. It can also be applied for a disc using an Al alloy as a reflection film.

Moreover, the layer structure of a recording medium using an oxide thin film of the present invention is not limited. For example, the present invention can be applied to various kinds of recording media such as a recording medium of a configuration without a light incident side substrate or a cover layer, a recording medium of a configuration having other material layers in addition to the protection layer, the recording film layer and the reflection layer, a recording medium of a configuration having the reflection film layer of two-layer structure, a recording medium of a configuration capable of multiple layer recording having one or more recording medium configuration further added to the position of the light incident side or light reflection side substrate, a recording medium such as a reproduction dedicated disc, and a recording medium of a shape other than a disc such as a card type.

Moreover, although an oxide thin film according to the present invention is used for an optical disc in the above embodiments, the oxide thin film according to the present invention can also be used as a transparent protection film for a flat panel display or a semiconductor element because the performances required for a protection layer (transparency, oxidation prevention, reduction prevention, or the like) are substantially same.

Moreover, although an example of sputtering using one target containing a niobium oxide and a silicon oxide or a titanium oxide is shown in the above embodiments, instead, a technique of forming films at the same time from a plurality of targets by co-sputtering using a niobium oxide and one of a silicon oxide and a titanium oxide as a target can also be adopted.

### INDUSTRIAL APPLICABILITY

The present invention can be utilized for the technology for forming an oxide protection film represented by a dielectric protection layer for a recording type optical disc such as an inorganic additional recording type disc, a phase change disc and an optical magnetic disc, and a protection film for a flat panel display.

## Claims

1. A thin film forming sputtering target comprising a titanium oxide as the main component, and a niobium oxide with the oxygen lacked.

2. The thin film forming sputtering target according to claim 1, wherein the stoichiometric composition ratio of the niobium atoms and the oxygen atoms is 2 to 3 in the niobium oxide with the oxygen lacked.

3. The thin film forming sputtering target according to claim 1, wherein the content ratio of the titanium oxide is substantially 96% by weight.

4. A dielectric protection film comprising:
a titanium oxide or a niobium oxide, serving as the main component, with the oxygen lacked from the stoichiometric composition.

5. The dielectric protection film according to claim 4, wherein the titanium oxide serves as the main component, wherein the titanium oxide is contained by 96% by weight, and wherein a niobium oxide is contained.

6. The dielectric protection film according to claim 4, wherein the niobium oxide serves as the main component, and wherein a silicon oxide is contained by 1 to 30% by weight.

7. The dielectric protection film according to claim 4, further comprising nitrogen.

8. An optical disc comprising the dielectric protection film according to claim 4.

9. A flat panel display comprising the dielectric protection film according to claim 4.

10. A production method of a dielectric protection film, comprising a process of carrying out sputtering using the sputtering target according to claim 1.

11. The production method of a dielectric protection film according to claim 10, wherein the sputtering process is carried out in an atmosphere with nitrogen or oxygen introduced in an inert gas.

12. The production method of a dielectric protection film according to claim 11, wherein the atmosphere is an inert gas with the oxygen added by 3%.

13. The production method of a dielectric protection film according to claim 11, wherein the atmosphere is an inert gas with the nitrogen added by 5%.

14. A production method of a dielectric protection film, comprising a process of carrying out sputtering using a sputtering target containing a niobium oxide with the oxygen lacked as the main component, and 1 to 30% by weight of a silicon oxide, wherein the stoichiometric composition ratio of the niobium oxide of the niobium atoms to the oxygen atoms of the sputtering target is 2 to 3.

15. The production method of a dielectric protection film according to claim 14, wherein the sputtering process is carried out in an atmosphere with nitrogen or oxygen introduced in an inert gas.

16. The production method of a dielectric protection film according to claim 15, wherein the atmosphere is an inert gas with the oxygen added by 5% with the pressure of 0.2 Pa or less.

17. The production method of a dielectric protection film according to claim 15, wherein the atmosphere is an inert gas with the oxygen added by 3% with the pressure of 0.4 Pa or less.

18. The production method of a dielectric protection film according to claim 15, wherein the atmosphere is an inert gas with the nitrogen added by 5% with the pressure of 0.4 Pa or less.
